# EUROPEAN PATENT APPLICATION

(11) **EP 4 373 234 A1**
(43) Date of publication of application: **22.05.2024**
(21) Application number: 23188617.7
(22) Date of filing: 31.07.2023
(51) Int. Cl.: H10B 12/00, H01L 21/764, H01L 29/786

(54) **SEMICONDUCTOR MEMORY DEVICE**

(30) Priority: 18.11.2022 KR 20220155017
(71) Applicant: Samsung Electronics Co., Ltd., Suwon-si, Gyeonggi-do 16677 (KR)
(72) Inventor: CHOI, Deokhwan, 16677 Suwon-si (KR); PARK, Julpin, 16677 Suwon-si (KR); BAE, In-Jae, 16677 Suwon-si (KR); PARK, Dong-Sik, 16677 Suwon-si (KR)
(74) Representative: Marks & Clerk LLP

(57) **Abstract**

A semiconductor memory device includes a bit line on a substrate and extending in a first direction, first and second active pillars on the bit line, the first active pillar including a first horizontal portion coupled to the bit line and a first vertical portion extending from the first horizontal portion, the second active pillar including a second horizontal portion coupled to the bit line and a second vertical portion extending from the second horizontal portion. First and second word lines are on the first and second horizontal portions of the first and second active pillars, respectively, and extend in a second direction crossing the first direction. A first insulating layer is between the first and second word lines. A first and second side surfaces of the first and second horizontal portions face each other. The first insulating layer includes an air gap between the first and second side surfaces.

## Description

### FIELD

The present disclosure relates to a semiconductor memory device, and in particular, to a semiconductor memory device including vertical channel transistors and a method of fabricating the same.

### BACKGROUND

As design rules of semiconductor devices decrease, advances in manufacturing technology may improve the integration density, operation speed, and yield of semiconductor devices. A semiconductor device with a vertical channel transistor has been suggested to increase an integration density of a semiconductor device and improve resistance and current driving characteristics of the transistor.

### SUMMARY

An embodiment of the inventive concept provides a semiconductor memory device having improved electrical characteristics and an increased integration density.

An embodiment of the inventive concept provides a method of fabricating a semiconductor memory device having improved electrical characteristics and an increased integration density.

According to an embodiment of the inventive concept, a semiconductor memory device may include a bit line on a substrate and extending in a first direction, a first active pillar and a second active pillar on the bit line, the first active pillar including a first horizontal portion coupled to the bit line and a first vertical portion extending from the first horizontal portion in a vertical direction away from the substrate, the second active pillar including a second horizontal portion coupled to the bit line and a second vertical portion extending from the second horizontal portion in the vertical direction, a first word line and a second word line on the first and second horizontal portions of the first and second active pillars, respectively, and extending in a second direction crossing the first direction, and a first insulating layer between the first and second word lines. A first side surface of the first horizontal portion and a second side surface of the second horizontal portion may face each other, and the first insulating layer may include a first air gap between the first side surface and the second side surface.

According to an embodiment of the inventive concept, a semiconductor memory device may include a bit line on a substrate and extending in a first direction, first active pillars and second active pillars on the bit line, the first and second active pillars being alternately arranged in the first direction, each of the first and second active pillars including a horizontal portion coupled to the bit line and a vertical portion extending from the horizontal portion in a vertical direction away from the substrate, first word lines on the horizontal portions of the first active pillars, respectively, second word lines on the horizontal portions of the second active pillars, respectively, the first and second word lines being extending in a second direction crossing the first direction, a first insulating layer between the first word line and the second word line, which are adjacent to each other, and a second insulating layer between the vertical portion of the first active pillar and the vertical portion of the second active pillar, which are adjacent to each other. The first insulating layer may include a first air gap, and the second insulating layer may include a second air gap. The second air gap may be positioned to be higher than the first air gap relative to the substrate.

According to an embodiment of the inventive concept, a semiconductor memory device may include a peripheral circuit structure including peripheral circuits, which are on a substrate, a bit line on the peripheral circuit structure and extending in a first direction, a first active pillar and a second active pillar on the bit line, the first active pillar including a first horizontal portion coupled to the bit line and a first vertical portion extending from the first horizontal portion in a vertical direction away from the substrate, the second active pillar including a second horizontal portion coupled to the bit line and a second vertical portion extending from the second horizontal portion in the vertical direction, a first word line and a second word line on the first and second horizontal portions of the first and second active pillars, respectively, and extending in a second direction crossing the first direction, a first gate insulating layer between the first active pillar and the first word line and a second gate insulating layer between the second active pillar and the second word line, a first insulating layer between the first and second word lines, a gate capping pattern on top surfaces of the first and second word lines and a top surface of the first insulating layer, landing pads on the first and second active pillars, respectively, and a plurality of data storage patterns on the landing pads, respectively. The first insulating layer may include at least one air gap.

At least some of the above and other features of the invention are set out in the claims.

### BRIEF DESCRIPTION OF THE DRAWINGS

FIG. 1 is a block diagram illustrating a semiconductor memory device according to an embodiment of the inventive concept.
FIGS. 2 and 3 are perspective views briefly illustrating a semiconductor memory device according to an embodiment of the inventive concept.
FIG. 4 is a plan view illustrating a semiconductor memory device according to an embodiment of the inventive concept.
FIG. 5A is a sectional view taken along a line A-A' of FIG. 4.
FIG. 5B is a sectional view taken along a line B-B' of FIG. 4.
FIG. 5C is a sectional view taken along a line C-C' of FIG. 4.
FIGS. 6A, 6B, 6C, 7A, 7B, 7C, 8A, 8B, 8C, 9A, 9B, 9C, 10A, 10B, 10C, 11A, 11B, and 11C are sectional views illustrating a method of fabricating a semiconductor memory device, according to an embodiment of the inventive concept.
FIGS. 12, 13, 14, and 15 are sectional views, each of which is taken along the line A-A' of FIG. 4, illustrating a semiconductor memory device according to an embodiment of the inventive concept.

### DETAILED DESCRIPTION OF EMBODIMENTS

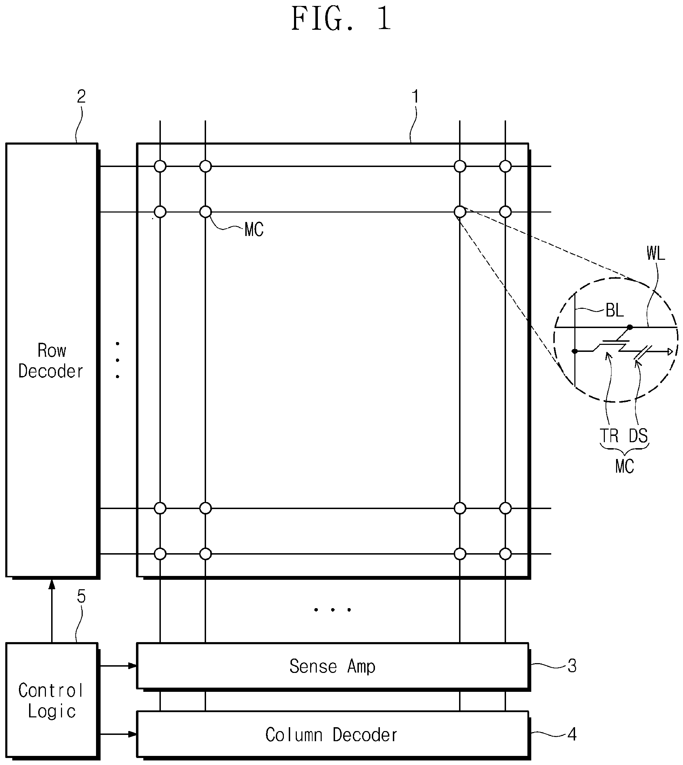

FIG. 1 is a block diagram illustrating a semiconductor memory device according to an embodiment of the inventive concept. Referring to FIG. 1, a semiconductor memory device may include a memory cell array 1, a row decoder 2, a sense amplifier 3, a column decoder 4, and a control logic 5. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items.

The memory cell array 1 may include a plurality of memory cells MC, which are two- or three-dimensionally arranged. Each of the memory cells MC may be disposed between and connected to word lines WL and bit lines BL, which are disposed in respective directions to cross each other.

Each of the memory cells MC may include a selection element TR and a data storage device DS. The selection element TR and the data storage device DS may be electrically connected to each other. The selection element TR may be connected to both of the word and bit lines WL and BL. In other words, the selection element TR may be provided at an intersection of the word and bit lines WL and BL.

The selection element TR may include a field effect transistor. The data storage device DS may include a capacitor, a magnetic tunnel junction pattern, or a variable resistor. In an embodiment, a gate terminal of a transistor, which is used as the selection element TR, may be connected to the word line WL, and source/drain terminals of the transistor may be respectively connected to the bit line BL and the data storage device DS.

The row decoder 2 may be configured to decode address information, which is input from the outside (e.g., from an external circuit), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may be used as a data transmission path between the sense amplifier 3 and an external device (e.g., a memory controller). The column decoder 4 may be configured to decode address information, which is input from the outside, and to select one of the bit lines BL, based on the decoded address information.

The control logic 5 may generate control signals, which are used to control an operation of writing or reading data to or from the memory cell array 1.

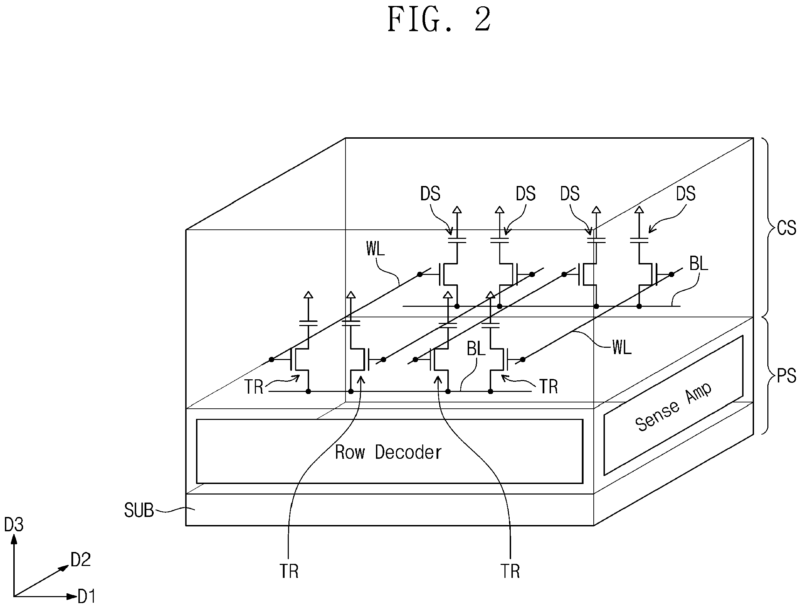

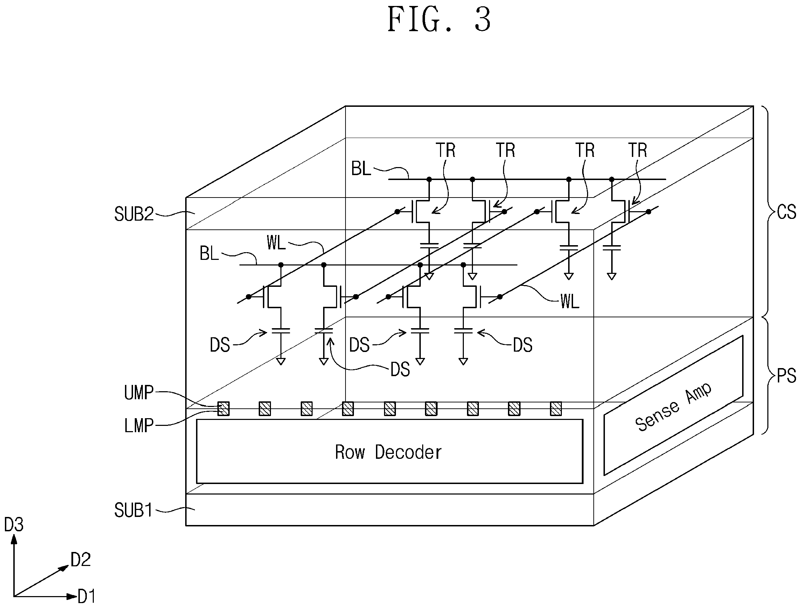

FIGS. 2 and 3 are perspective views briefly illustrating a semiconductor memory device according to an embodiment of the inventive concept. Referring to FIGS. 2 and 3, a semiconductor memory device may include a peripheral circuit structure PS and a cell array structure CS, which are connected to each other.

The peripheral circuit structure PS may include core and peripheral circuits formed on a substrate SUB. The core and peripheral circuits may include the row and column decoders 2 and 4, the sense amplifier 3, and the control logic 5 described with reference to FIG. 1.

The cell array structure CS may include the memory cell array 1, in which the memory cells MC are two- or three-dimensionally arranged (e.g., see FIG. 1). Each of the memory cells MC of FIG. 1 may include the selection element TR and the data storage device DS, as described above.

In an embodiment, the selection element TR of each of the memory cells MC of FIG. 1 may include a vertical channel transistor (VCT). The vertical channel transistor may include a channel which is elongated in a direction (i.e., a third direction D3) away from or perpendicular to a top surface of the substrate SUB, also referred to herein as a vertical direction. The top surface of the substrate SUB may be the surface that faces towards the cell structure CS. The top surface of the substrate SUB may be the surface upon which the cell structure CS (and optionally the peripheral circuit PS) is formed. The data storage device DS of each of the memory cells MC of FIG. 1 may include a capacitor.

In the embodiment of FIG. 2, the peripheral circuit structure PS may be provided on the substrate SUB, and the cell array structure CS may be provided on the peripheral circuit structure PS.

In the embodiment of FIG. 3, the peripheral circuit structure PS may be provided on a first substrate SUB1, and the cell array structure CS may be provided on a second substrate SUB2. The first and second substrates SUB1 and SUB2 may be provided to face each other.

First metal pads LMP may be provided at the uppermost level of the peripheral circuit structure PS. The first metal pads LMP may be electrically connected to the core and peripheral circuits 2, 3, 4, and 5 of FIG. 1.

Second metal pads UMP may be provided at the lowermost level of the cell array structure CS. The second metal pads UMP may be electrically connected to the memory cell array 1 of FIG. 1. The second metal pads UMP may be directly bonded to the first metal pads LMP of the peripheral circuit structure PS to be in direct contact with the first metal pads LMP along a bonding interface therebetween. It will be appreciated that the terms "upper" and "lower" are relative terms (e.g. indicating a height, or distance, along the third direction D3, such as from a top surface of the first substrate SUB1) and need not relate to a particular orientation of the semiconductor device in use.

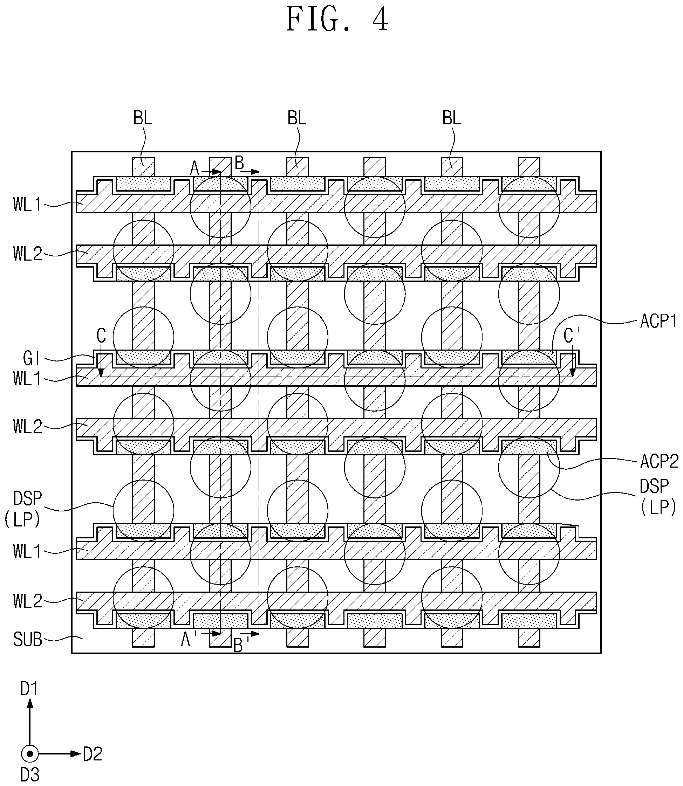

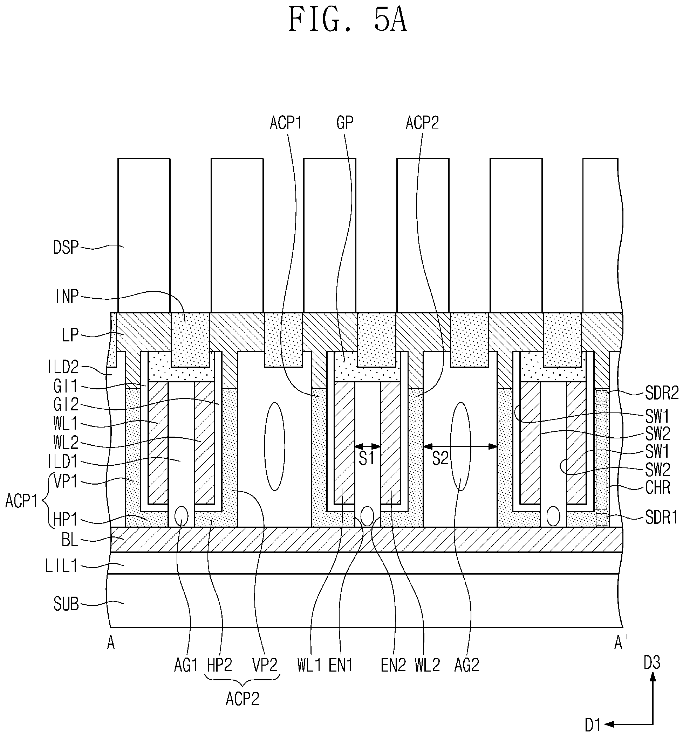

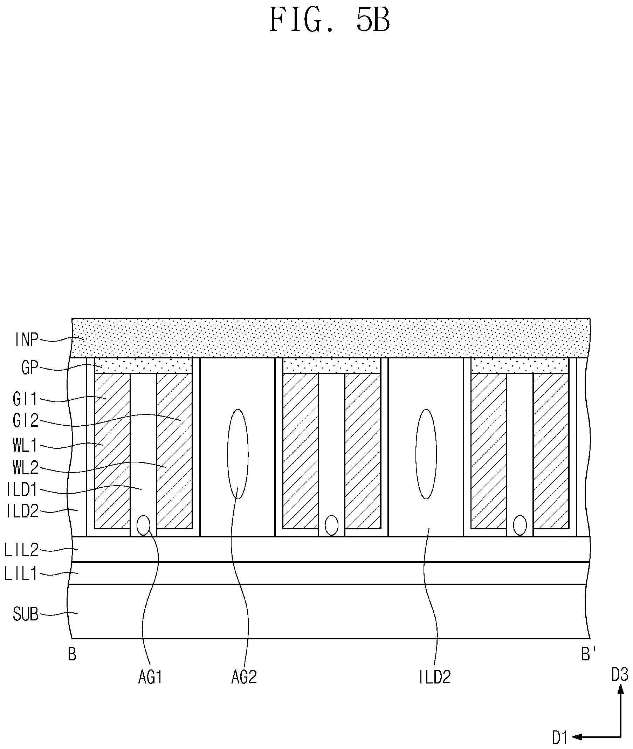

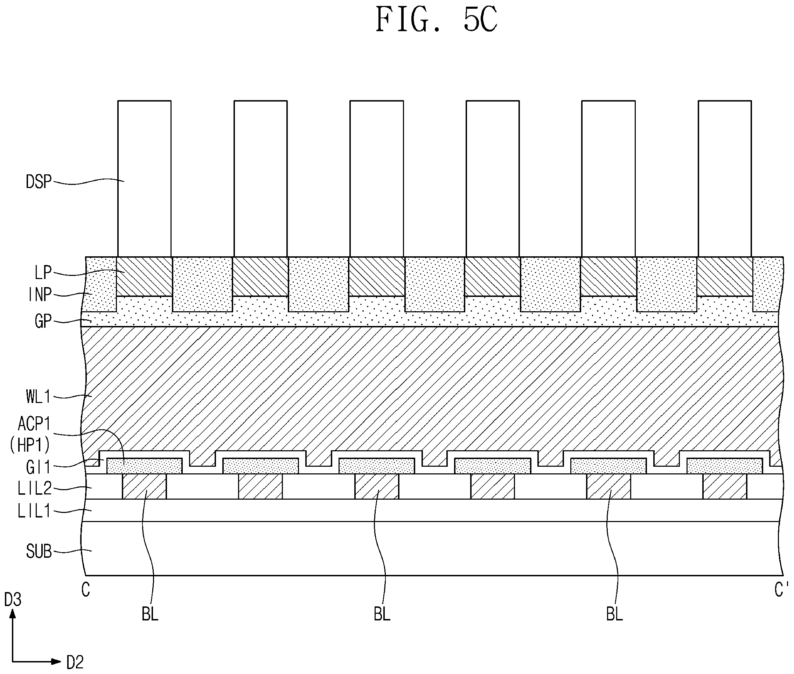

FIG. 4 is a plan view illustrating a semiconductor memory device according to an embodiment of the inventive concept. FIG. 5A is a sectional view taken along a line A-A' of FIG. 4. FIG. 5B is a sectional view taken along a line B-B' of FIG. 4. FIG. 5C is a sectional view taken along a line C-C' of FIG. 4.

Referring to FIGS. 4 and 5A to 5C, a first lower insulating layer LIL1 may be provided on the substrate SUB. As an example, the peripheral circuit structure PS previously described with reference to FIG. 2 may be provided between the substrate SUB and the first lower insulating layer LIL1. In an embodiment, an integrated circuit (e.g., a logic device) may be provided between the substrate SUB and the first lower insulating layer LIL1.

A second lower insulating layer LIL2 may be provided on the first lower insulating layer LIL1. A plurality of bit lines BL may be provided in the second lower insulating layer LIL2. The bit lines BL may extend in a first direction D1 to be parallel to each other. The bit lines BL may be arranged at a specific pitch in a second direction D2. Each of the bit lines BL may have a linewidth ranging from about 1 nm to about 50 nm. The first direction D1 may cross (e.g. may be perpendicular to) the second direction D2. The first direction D1 and the second direction D2 may be perpendicular to the third direction D3. The first direction D1 and the second direction D2 may be parallel to a top surface of the substrate SUB.

In an embodiment, the bit lines BL may be formed of or include at least one of doped semiconductor materials (e.g., doped silicon and doped germanium), conductive metal nitride materials (e.g., titanium nitride and tantalum nitride), metallic materials (e.g., tungsten, titanium, and tantalum), or metal-semiconductor compounds (e.g., tungsten silicide, cobalt silicide, and titanium silicide). Each of the bit lines BL may include a single conductive layer or a plurality of conductive layers. The first and second lower insulating layers LIL1 and LIL2 may include a silicon oxide layer, a silicon nitride layer, a silicon oxynitride layer, and/or a low-k dielectric layer. A low-k dielectric layer may comprise a low-k dialectic material, which may be a material that has a dielectric constant (k) that is less than that of silicon dioxide.

Active pillars ACP may be provided on the bit lines BL. Each of the active pillars ACP may have a lengthwise direction in the third direction D3. The active pillars ACP may include a first active pillar ACP1 and a second active pillar ACP2, which are disposed to be adjacent to each other in the first direction D1 and are paired with each other. The first and second active pillars ACP1 and ACP2 may have symmetric shapes with respect to one another, for example, along an axis of symmetry in the vertical direction. The first and second active pillars ACP1 and ACP2 on each bit line BL may be alternately arranged in the first direction D1.

The first active pillar ACP1 may include a plurality of the first active pillars ACP1, which are arranged in the second direction D2 or along a first word line WL1 to be described below. The first active pillars ACP1, which are adjacent to each other, may be spaced apart from each other in the second direction D2. The second active pillar ACP2 may include a plurality of the second active pillars ACP2, which are arranged in the second direction D2 or along a second word line WL2 to be described below. The second active pillars ACP2, which are adjacent to each other, may be spaced apart from each other in the second direction D2.

Each of the first active pillars ACP1 may include a first horizontal portion HP1 and a first vertical portion VP1, which extends from the first horizontal portion HP1 vertically (i.e., in the third direction D3), i.e., in the vertical direction. The first horizontal portion HP1 may be in direct contact with the bit line BL.

Each of the second active pillars ACP2 may include a second horizontal portion HP2 and a second vertical portion VP2, which extends from the second horizontal portion HP2 vertically (i.e., in the third direction D3). The second horizontal portion HP2 may be in direct contact with the bit line BL.

Each of the first and second vertical portions VP1 and VP2 may be elongated in a direction away from or perpendicular to the top surface of the substrate SUB. Each of the first and second vertical portions VP1 and VP2 may have a width in the first direction D1. For example, the width (e.g. in the first direction D1) of each of the first and second vertical portions VP1 and VP2 may range from 1 nm to 30 nm, in particular, from 1 nm to 10 nm. A vertical length (e.g. in the third direction D3) of each of the first and second vertical portions VP1 and VP2 may be 2 to 10 times the width.

The first and second horizontal portions HP1 and HP2 may be in direct contact with a top surface of the bit line BL. A thickness (e.g. in the third direction D3) of each of the first and second horizontal portions HP1 and HP2 may be substantially equal to the width of each of the first and second vertical portions VP1 and VP2. That is, each of the first and second active pillars ACP1 and ACP2 may have a uniform thickness.

Each of the first and second active pillars ACP1 and ACP2 may include end portions, which are opposite to each other in the third direction D3. Each of the first and second active pillars ACP1 and ACP2 may include a first source/drain region SDR1 and a second source/drain region SDR2, which are respectively provided at the opposite end portions thereof. Each of the first and second active pillars ACP1 and ACP2 may further include a channel region CHR between the first and second source/drain regions SDR1 and SDR2.

The channel region CHR of the active pillar ACP may be controlled by the word line WL adjacent thereto. In detail, conduction in the channel region CHR of the first active pillar ACP1 may be controlled by the first word line WL1. Conduction in the channel region CHR of the second active pillar ACP2 may be controlled by the second word line WL2.

In an embodiment, each of the first and second active pillars ACP1 and ACP2 may be formed of or include at least one of oxide semiconductor materials and two-dimensional materials. The active pillar ACP may have a band gap energy that is higher than that of silicon. For example, the active pillar ACP may have a band gap energy of about 1.5 eV to 5.6 eV. In an embodiment, the device may exhibit an optimized or desired channel performance, when the band gap energy of the active pillar ACP ranges from about 2.0 eV to about 4.0 eV.

In detail, the oxide semiconductor material may be formed of or include a compound containing at least two metallic elements selected from zinc (Zn), indium (In), gallium (Ga), and tin (Sn) and oxygen (O). In an embodiment, the active pillar ACP may be formed of or include at least one amorphous oxide semiconductor material, such as InGaZnO, InGaSiO, InSnZnO, InZnO, ZnO, ZnSnO, ZnON, ZrZnSnO, SnO, HfInZnO, GaZnSnO, AlZnSnO, YbGaZnO, and InGaO.

In detail, the two-dimensional material may include at least one of metal chalcogenide, transition metal chalcogenide, graphene, phosphorene, or carbon nanotube. The metal chalcogenide or transition metal chalcogenide may be a metal compound, which can be represented by the chemical formula of MXy, where y is an integer (e.g., 1, 2, or 3). In the chemical formula, M is a metal atom or a transition metal atom and may include, for example, W, Mo, Ti, Zn, or Zr. In the chemical formula, X is a chalcogen atom and may include, for example, S, Se, O, or Te. For example, the two-dimensional material may include at least one selected from graphene, phosphorene, MoS₂, MoSe₂, MoTe₂, WS₂, WSe₂, WTe₂, ReS₂, ReSe₂, TiS₂, TiSe₂, TiTe₂, ZnO, ZnS₂, WO₃, and MoOs.

The active pillar ACP may have a mono-layered structure or a multi-layered structure, in which 2 to 100 layers are stacked. The multi-layered structure may be realized using several pairs of monolayers coupled by a Van der Waals force.

In an embodiment, each of the first and second active pillars ACP1 and ACP2 may be formed of or include a semiconductor material (e.g., silicon, germanium, or silicon-germanium).

The first and second word lines WL1 and WL2 may be provided on the bit lines BL to cross the bit lines BL. The first word lines WL1 may extend in the second direction D2, on the first horizontal portions HP1 of the first active pillars ACP1 (e.g., see FIG. 5C). The second word lines WL2 may extend in the second direction D2, on the second horizontal portions HP2 of the second active pillars ACP2.

The first and second word lines WL1 and WL2 may be alternately arranged in the first direction D1. A pair of first and second word lines WL1 and WL2 may be disposed between a pair of first and second active pillars ACP1 and ACP2 (e.g., see FIG. 5A). That is, the pair of first and second word lines WL1 and WL2 may be disposed between the pair of first and second vertical portions VP1 and VP2. A first insulating layer ILD1 may be interposed between the pair of first and second word lines WL1 and WL2.

Each of the first and second word lines WL1 and WL2 may have a first side surface SW1 and a second side surface SW2, which are opposite to each other (e.g., see FIG. 5A). The first side surface SW1 of each of the first and second word lines WL1 and WL2 may be adjacent to the vertical portion VP1 or VP2 of the active pillar ACP1 or ACP2. The second side surfaces SW2 of the first and second word lines WL1 and WL2, which are paired with each other, may face each other. The first insulating layer ILD1 may be interposed between the second side surfaces SW2 of the first and second word lines WL1 and WL2, which are paired with each other.

In an embodiment, the first and second word lines WL1 and WL2 may be formed of or include at least one of doped semiconductor materials (e.g., doped silicon and doped germanium), conductive metal nitride materials (e.g., titanium nitride and tantalum nitride), metallic materials (e.g., tungsten, titanium, and tantalum), or metal-semiconductor compounds (e.g., tungsten silicide, cobalt silicide, and titanium silicide).

A first gate insulating layer GI1 may be disposed between the first word line WL1 and the first active pillars ACP1, which are arranged in the second direction D2. The first gate insulating layer GI1 may be interposed between the first side surface SW1 of the first word line WL1 and the first vertical portion VP1 of the first active pillar ACP1. The first gate insulating layer GI1 may be interposed between a bottom surface of the first word line WL1 and the first horizontal portion HP1 of the first active pillar ACP1. The first gate insulating layer GI1 may have a uniform thickness.

The first gate insulating layer GI1 may be in direct contact with a top surface of the second lower insulating layer LIL2 and a side surface of the second insulating layer ILD2, between the first active pillars ACP1, which are adjacent to each other in the second direction D2 (e.g., see FIG. 5B). When components or layers are referred to as "directly on" or "directly connected" or "in direct contact", no intervening components or layers are present.

A second gate insulating layer GI2 may be disposed between the second word line WL2 and the second active pillars ACP2, which are arranged in the second direction D2. The second gate insulating layer GI2 may be interposed between the first side surface SW1 of the second word line WL2 and the second vertical portion VP2 of the second active pillar ACP2. The second gate insulating layer GI2 may be interposed between a bottom surface of the second word line WL2 and the second horizontal portion HP2 of the second active pillar ACP2. The second gate insulating layer GI2 may have a uniform thickness.

The first and second gate insulating layers GI1 and GI2 may be formed of or include at least one of silicon oxide, silicon oxynitride, one or more high-k dielectric materials (e.g. one or more materials having a higher dielectric constant than silicon oxide), or combinations thereof. The one or more high-k dielectric materials may include one or more metal oxide materials or one or more metal oxynitride materials. For example, the one or more high-k dielectric materials may include HfO₂, HfSiO, HfSiON, HfTaO, HfTiO, HfZrO, ZrO₂, or Al₂O₃.

The first insulating layer ILD1 may be provided between the first and second word lines WL1 and WL2, which are adjacent to each other. The first insulating layer ILD1 may be provided to fill a space between the first and second horizontal portions HP1 and HP2 of the first and second active pillars ACP1 and ACP2, which are adjacent to each other. The term "fill" may be used herein to refer to either completely filling or partially filling a defined space, for example, such that voids or other spaces may be present. In an embodiment, the first insulating layer ILD1 may include a silicon oxide layer, a silicon nitride layer, a silicon oxynitride layer, and/or a low-k dielectric layer.

The first insulating layer ILD1 may include at least one first air gap AG1. In the present embodiment, the first air gap AG1 may be provided in a lower portion of the first insulating layer ILD1. The first air gap AG1 may be provided between the first and second horizontal portions HP1 and HP2, which are adjacent to each other. In particular, the first and second horizontal portions HP1 and HP2 of the first and second active pillars ACP1 and ACP2 may include first and second side surfaces EN1 and EN2 facing each other. The first and second side surfaces EN1 and EN2 may be vertically aligned to (e.g., coplanar with) the side surfaces of the first and second word lines WL1 and WL2, respectively. In the present embodiment, the first air gap AG1 may be interposed between the first and second side surfaces EN1 and EN2 of the first and second horizontal portions HP1 and HP2.

The first air gap AG1 may improve an interference or dynamic disturb issue, which may occur between the first and second horizontal portions HP1 and HP2. The first air gap AG1 may reduce a coupling noise issue, which may occur between adjacent ones of the first and second active pillars ACP1 and ACP2 when the vertical channel transistors are operated. As a result, it may be possible to improve electrical characteristics of the semiconductor memory device.

A gate capping pattern GP may be provided on the first insulating layer II,D1. The gate capping pattern GP may cover top surfaces of the first and second word lines WL1 and WL2, which are adjacent to each other. In an embodiment, the gate capping pattern GP may include a silicon nitride layer or a silicon oxynitride layer.

Adjacent ones of the first and second word lines WL1 and WL2 may be spaced apart from each other by a first distance S1 by the first insulating layer II,D1. Adjacent ones of the first and second active pillars ACP1 and ACP2 may be spaced apart from each other by a second distance S2 by the second insulating layer ILD2. In an embodiment, the second distance S2 may be larger than the first distance S1. Accordingly, it may be possible to reduce a coupling noise issue, which may occur between adjacent ones of the first and second active pillars ACP1 and ACP2 when the vertical channel transistors are operated. It may be possible to reduce or prevent a leakage current from increasing between a transistor, which is selected when the device is operated, and an unselected transistor adjacent thereto. In an embodiment, the first distance S1 may be substantially equal to the second distance S2.

The second insulating layer ILD2 may be interposed between the first and second active pillars ACP1 and ACP2, which are adjacent to each other. For example, the second insulating layer ILD2 may include a silicon oxide layer, a silicon nitride layer, a silicon oxynitride layer, and/or a low-k dielectric layer.

The second insulating layer ILD2 may include at least one second air gap AG2. In the present embodiment, the second air gap AG2 may be positioned at a level higher than the first air gap AG1, relative to the substrate SUB. The second air gap AG2 may be larger than the first air gap AG1. Due to the presence of the second air gap AG2, an effective dielectric constant of the second insulating layer ILD2 may be lowered or reduced. Accordingly, it may be possible to reduce a coupling noise issue, which may occur between adjacent ones of the first and second active pillars ACP1 and ACP2 when the vertical channel transistors are operated.

Landing pads LP may be provided on the first and second active pillars ACP1 and ACP2, respectively. A lower portion of the landing pad LP may be in contact with a top surface of the active pillar ACP1 or ACP2. When viewed in a plan view, at least a portion of the landing pad LP may overlap the active pillar ACP1 or ACP2. A center of the landing pad LP may be offset from a center of the active pillar ACP1 or ACP2.

Referring back to FIG. 4, the landing pads LP may be arranged in a honeycomb shape when viewed in plan view. More specifically, the landing pads LP may be arranged in a zigzag shape in the first or second direction D1 or D2. In the case where the landing pads LP are arranged in the honeycomb shape, it may be possible to increase or maximize the number of the landing pads LP that can be formed within a given area. Thus, an integration density of the semiconductor memory device may be increased. When viewed in a plan view, the respective landing pads LP may have various shapes (e.g., circular, elliptical, rectangular, square, diamond, and hexagonal shapes).

In an embodiment, the landing pad LP may be formed of or include at least one of doped semiconductor materials (e.g., doped silicon and doped germanium), conductive metal nitride materials (e.g., titanium nitride and tantalum nitride), metallic materials (e.g., tungsten, titanium, and tantalum), or metal-semiconductor compounds (e.g., tungsten silicide, cobalt silicide, and titanium silicide).

An insulating pattern INP may be provided between the landing pads LP. The landing pads LP may be defined by forming the insulating pattern INP in a metal layer. The insulating pattern INP may be in direct contact with the gate capping pattern GP.

Data storage patterns DSP may be provided on the landing pads LP, respectively. The data storage patterns DSP may be electrically connected to the first and second active pillars ACP1 and ACP2, respectively, through the landing pads LP. When viewed in a plan view, the data storage patterns DSP may be disposed to be overlapped with the landing pads LP, respectively. In other words, the data storage patterns DSP may be arranged in the same shape (e.g., the honeycomb shape) as the landing pads LP. The landing pads LP provide electric connection between the data storage patterns DSP and the first and second active pillars ACP1 and ACP2.

In an embodiment, each of the data storage patterns DSP may be a capacitor. The data storage pattern DSP may include a bottom electrode, a top electrode, and a capacitor dielectric layer interposed therebetween. The bottom electrode may be in contact with the landing pad LP. For example, the bottom electrode may have a pillar shape or a hollow cylinder shape.

In an embodiment, each of the data storage patterns DSP may be a variable resistance pattern whose resistance can be switched to one of at least two states by an electric pulse applied thereto. For example, the data storage pattern DSP may be formed of or include at least one of phase-change materials whose crystal state can be changed depending on an amount of a current applied thereto, perovskite compounds, transition metal oxides, magnetic materials, ferromagnetic materials, or antiferromagnetic materials.

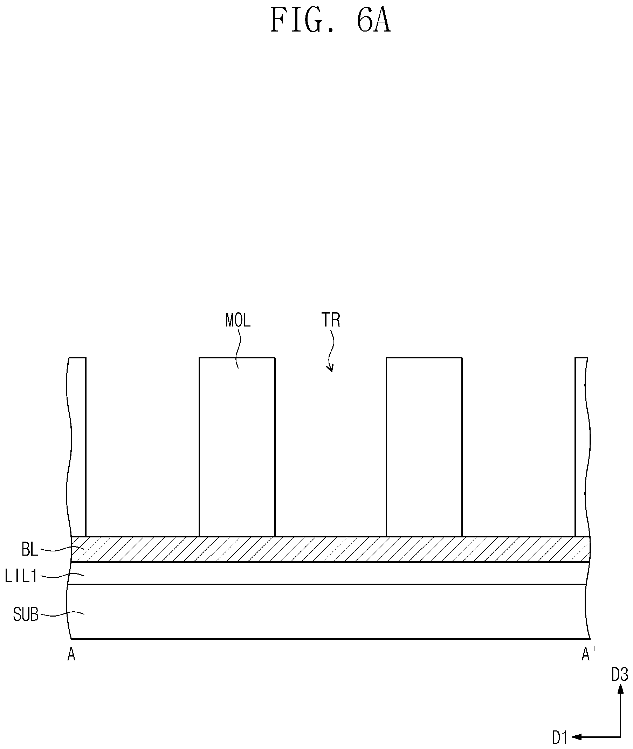

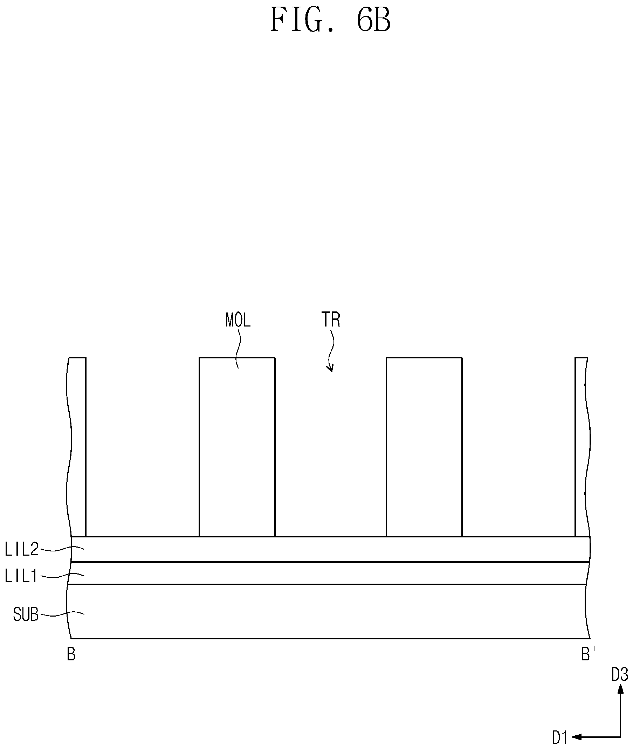

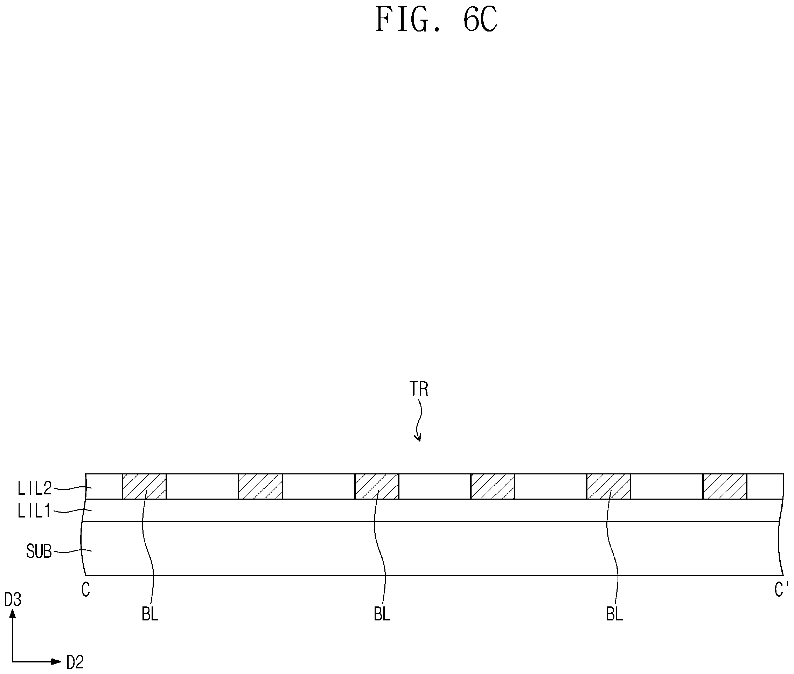

FIGS. 6A to 11C are sectional views illustrating a method of fabricating a semiconductor memory device, according to an embodiment of the inventive concept. FIGS. 6A, 7A, 8A, 9A, 10A, and 11A are sectional views taken along the line A-A' of FIG. 4. FIGS. 6B, 7B, 8B, 9B, 10B, and 11B are sectional views taken along the line B-B' of FIG. 4. FIGS. 6C, 7C, 8C, 9C, 10C, and 11C are sectional views taken along the line C-C' of FIG. 4.

Referring to FIG. 4 and FIGS. 6A to 6C, the first lower insulating layer LIL1 may be formed on the substrate SUB. The first lower insulating layer LIL1 may include a plurality of insulating layers stacked on the substrate SUB. For example, the first lower insulating layer LIL1 may include a silicon oxide layer, a silicon nitride layer, a silicon oxynitride layer, and/or a low-k dielectric layer.

The bit lines BL, which extend in the first direction D1, may be formed on the first lower insulating layer LIL1. The formation of the bit lines BL may include depositing a conductive layer on the first lower insulating layer LIL1 and patterning the conductive layer. The second lower insulating layer LIL2 may be formed between the bit lines BL. The top surface of the second lower insulating layer LIL2 may be coplanar with top surfaces of the bit lines BL.

In an embodiment, the formation of the bit lines BL may include forming trenches in the second lower insulating layer LIL2 and filling the trenches with a conductive material.

A mold layer MOL may be formed on the bit lines BL and the second lower insulating layer LIL2. A patterning process may be performed on the mold layer MOL to form a plurality of trenches TR. The trenches TR may extend in the second direction D2. The trenches TR may be arranged in and spaced apart from one another in the first direction D1. The trench TR may be formed to expose a portion of the bit line BL.

The mold layer MOL may be formed of or include an insulating material having an etch selectivity with respect to the second lower insulating layer LIL2. For example, the mold layer MOL may be formed of a silicon oxide layer, a silicon nitride layer, a silicon oxynitride layer, and/or a low-k dielectric layer.

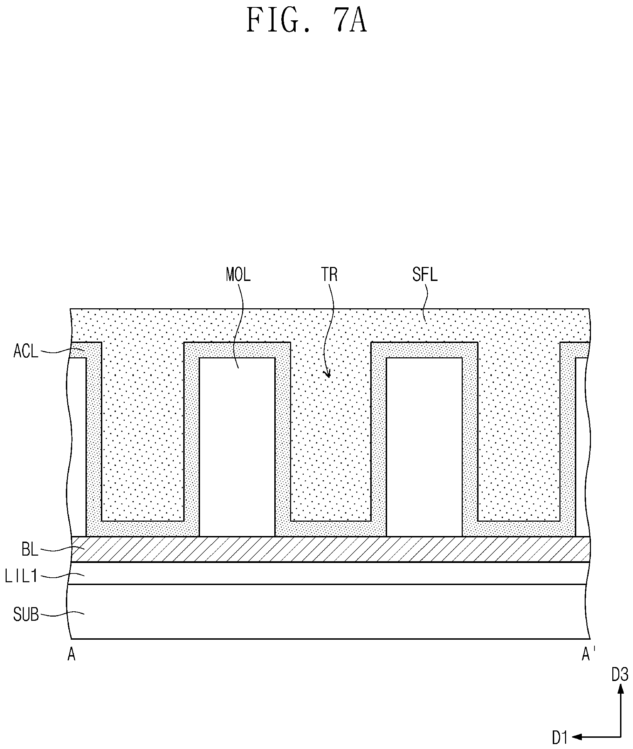

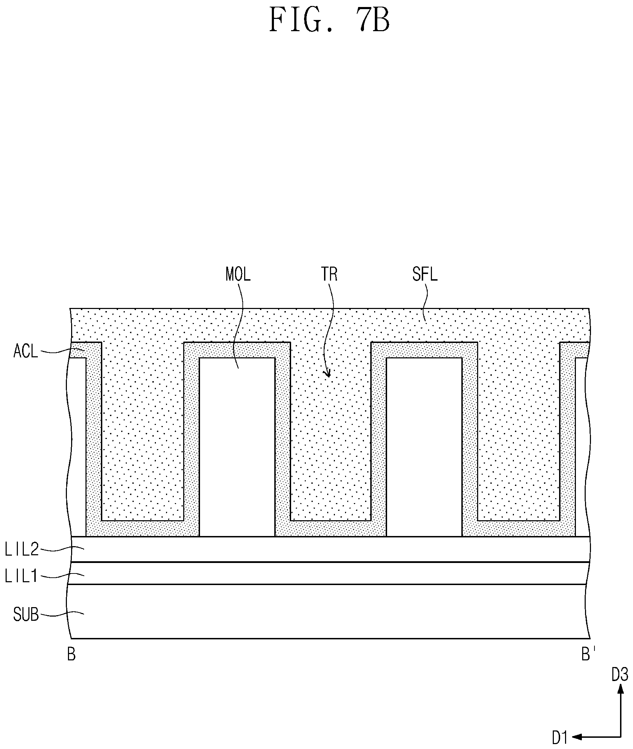

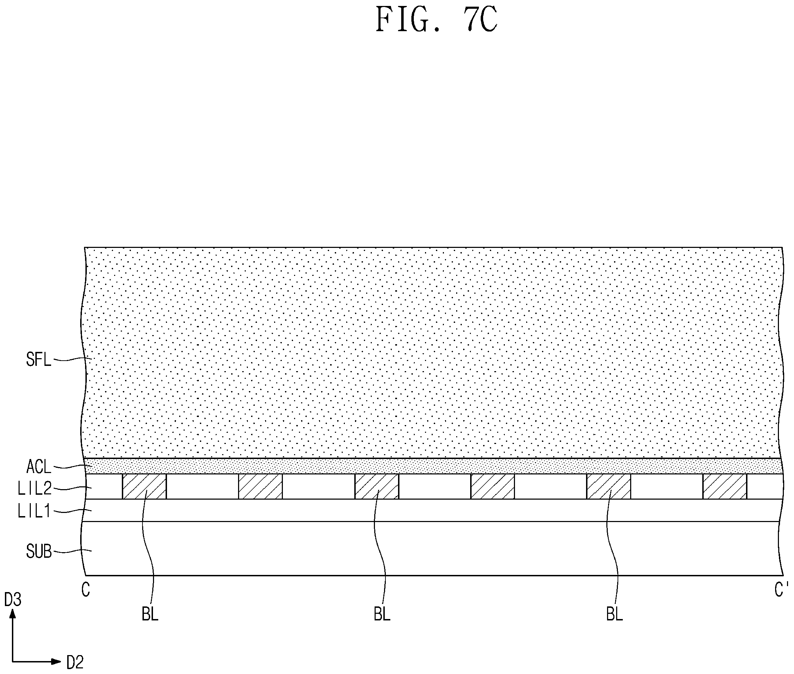

Referring to FIG. 4 and FIGS. 7A to 7C, an active layer ACL may be conformally formed on the mold layer MOL. The active layer ACL may cover an inner surface of the trench TR. The active layer ACL may be in contact with a portion of the bit line BL exposed by the trench TR.

The active layer ACL may be formed using at least one of a physical vapor deposition (PVD) process, a thermal chemical vapor deposition process, a low-pressure chemical vapor deposition (LP-CVD) process, a plasma-enhanced chemical vapor deposition (PE-CVD) process, and an atomic layer deposition (ALD) process. The active layer ACL may be formed of or include at least one of oxide semiconductor materials and two-dimensional materials. In an embodiment, the active layer ACL may be formed of or include at least one of amorphous oxide semiconductor materials including InGaZnO, InGaSiO, InSnZnO, InZnO, ZnO, ZnSnO, ZnON, ZrZnSnO, SnO, HfInZnO, GaZnSnO, AlZnSnO, YbGaZnO, and InGaO.

A sacrificial layer SFL may be formed on the active layer ACL to fill the trenches TR. The sacrificial layer SFL may be formed of or include an insulating material having an etch selectivity with respect to the mold layer MOL. In an embodiment, the sacrificial layer SFL may be formed of or include at least one of insulating materials, which are formed using a spin-on-glass (SOG) technology, or silicon oxide.

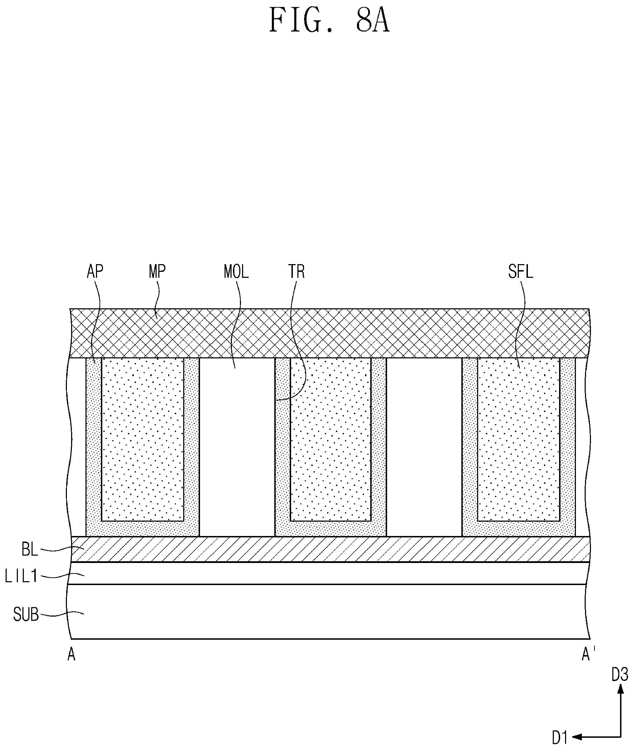

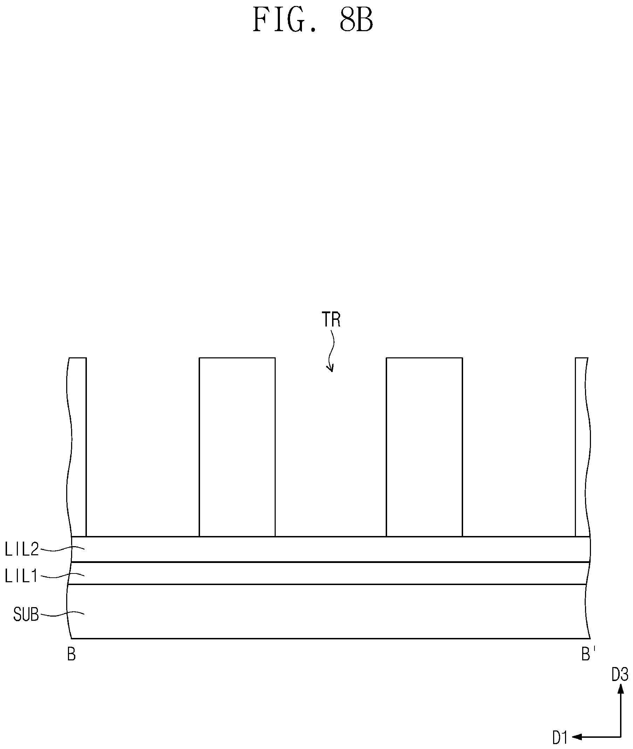

Referring to FIG. 4 and FIGS. 8A to 8C, a planarization process may be performed on the sacrificial and active layers SFL and ACL to expose a top surface of the mold layer MOL. Mask patterns MP may be formed on the planarized sacrificial and active layers SFL and ACL.

The mask patterns MP may extend in the first direction D1 to be parallel to each other. The mask patterns MP may be arranged in (e.g. may be spaced apart from each other in) the second direction D2. When viewed in a plan view, each of the mask patterns MP may be placed between the bit lines BL, which are adjacent to each other.

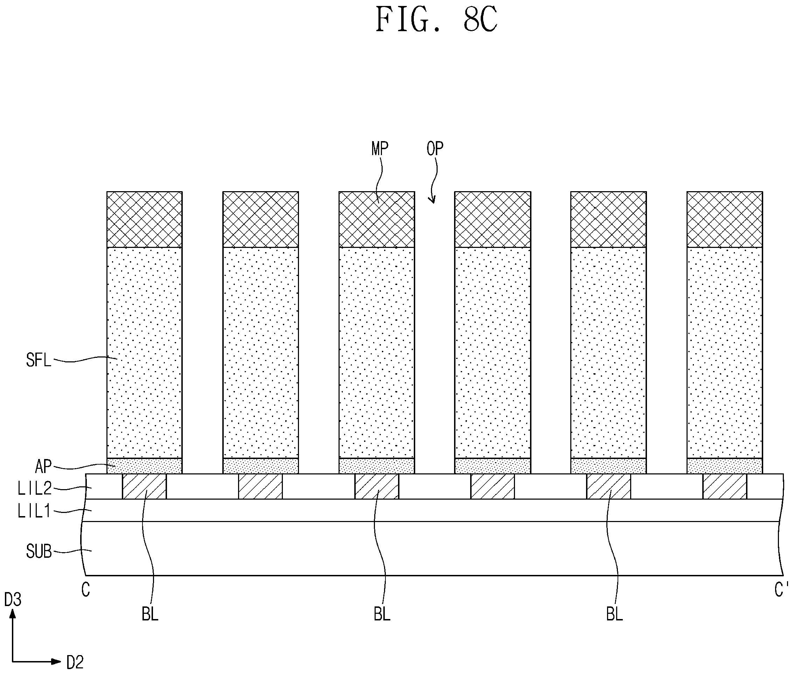

The sacrificial layer SFL and the active layer ACL may be selectively etched using the mask pattern MP as an etch mask. Thus, openings OP may be formed to expose the second lower insulating layer LIL2 between the bit lines BL (e.g., see FIG. 8C).

As a result of the etching process, each active layer ACL may be divided into a plurality of preliminary active pillars AP; that is, the etching process may be a node-separation process. Adjacent ones of the preliminary active pillars AP may be spaced apart from each other in the second direction D2 by the opening OP.

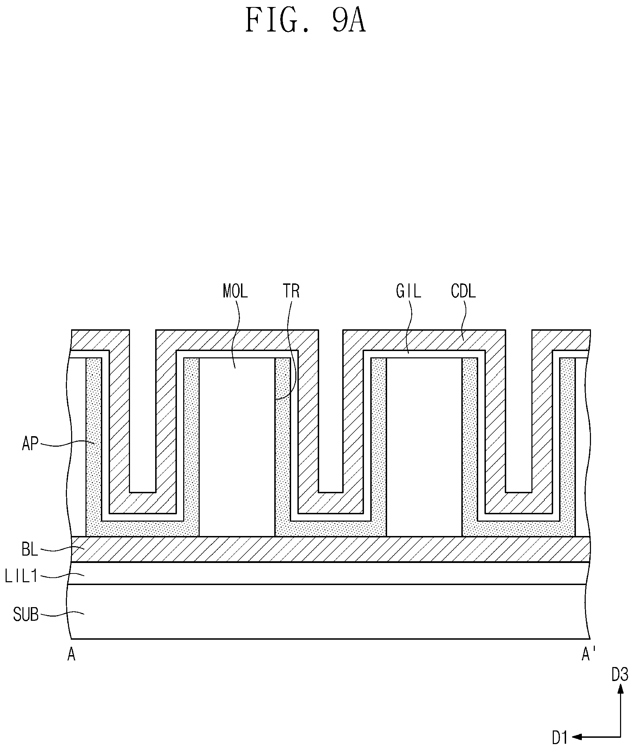

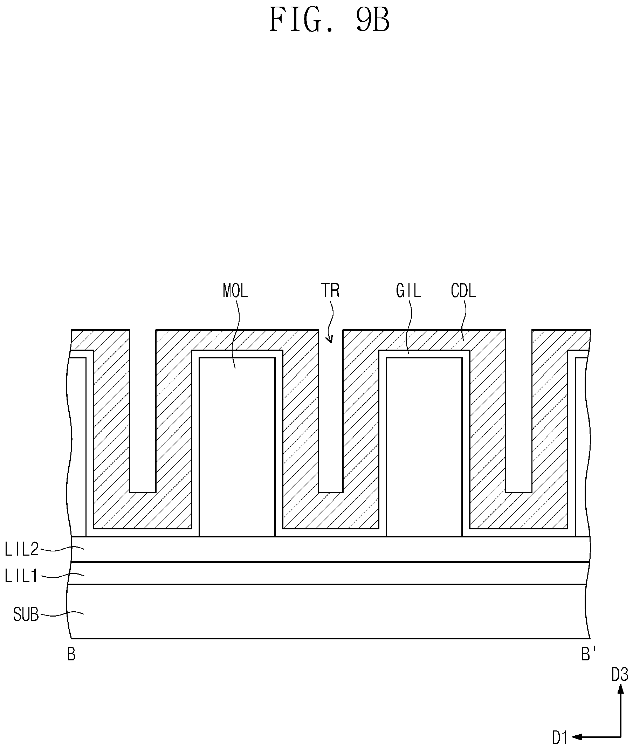

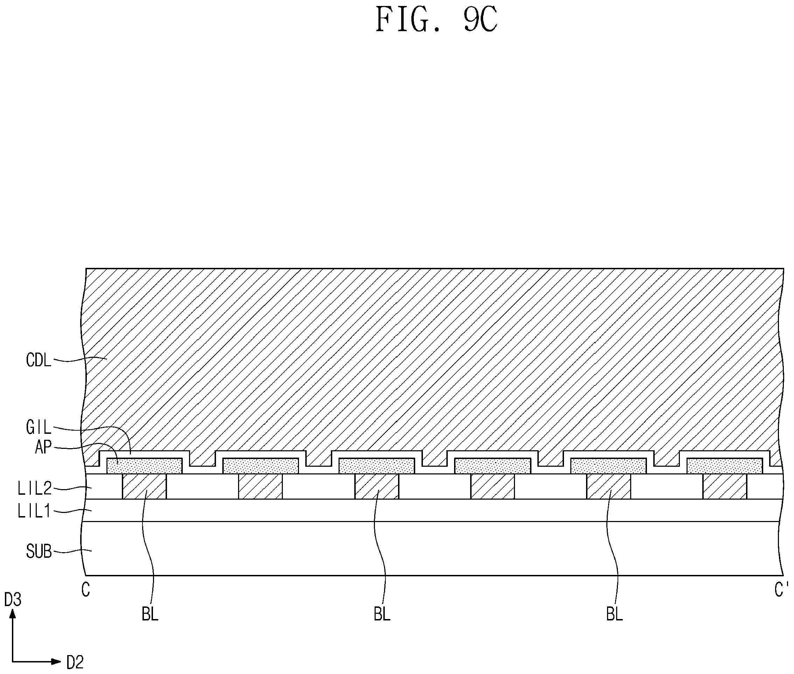

Referring to FIG. 4 and FIGS. 9A to 9C, the mask patterns MP may be selectively removed. The sacrificial layer SFL, which is exposed by the removal of the mask patterns MP, may be selectively removed. Accordingly, the preliminary active pillars AP in the trench TR may be exposed.

A gate insulating layer GII, and a gate conductive layer CDL may be sequentially formed on the preliminary active pillars AP. The gate insulating layer GIL and the gate conductive layer CDL may be formed using at least one of PVD, thermal CVD, LP-CVD, PE-CVD, and ALD processes.

A sum of thicknesses of the gate insulating layer GII, and the gate conductive layer CDL may be smaller than half of the width of the trench TR. In this case, the gate conductive layer (CDL) may only partially fill the trench (TR), rather than filling it completely.

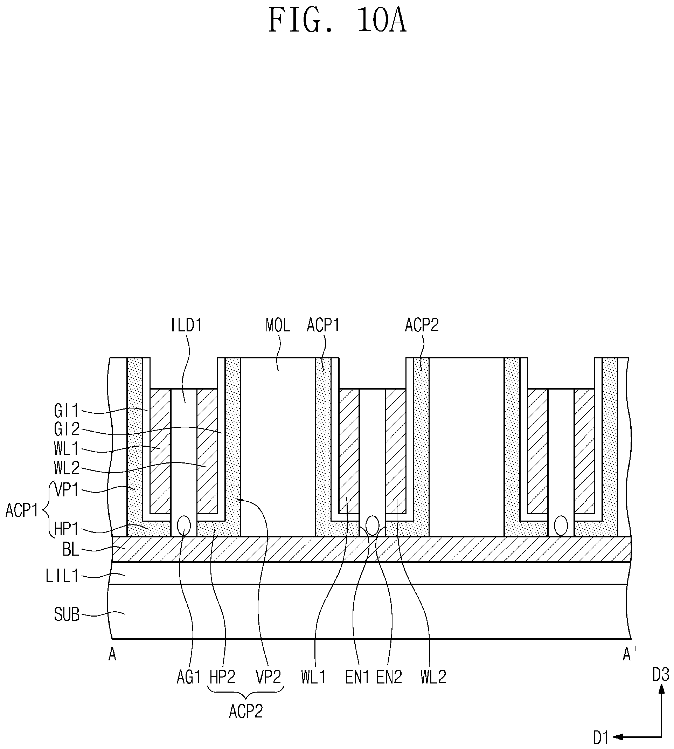

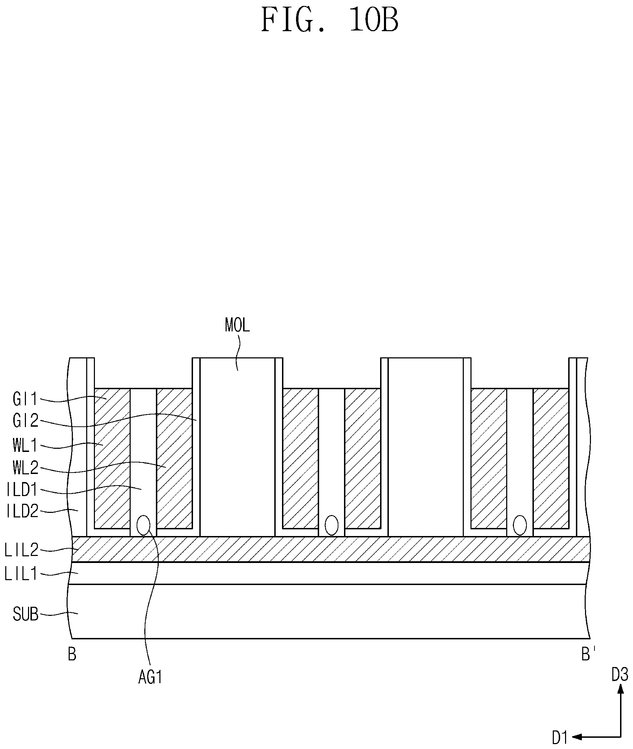

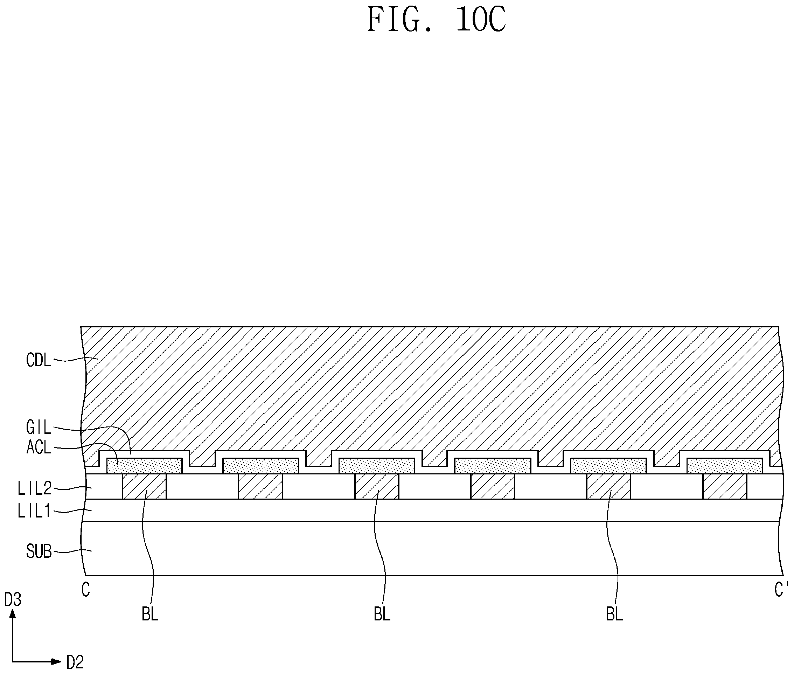

Referring to FIG. 4 and FIGS. 10A to 10C, an anisotropic etching process may be performed on the gate conductive layer CDL to form a pair of the first and second word lines WL1 and WL2, which are spaced apart from each other, in the trench TR.

The anisotropic etching process may be performed on the gate insulating layer GII, and the preliminary active pillars AP, which are not veiled or covered by the first and second word lines WL1 and WL2. Accordingly, a pair of the first and second active pillars ACP1 and ACP2, which are separated from each other, may be formed in the trench TR. Also, a pair of the first and second gate insulating layers GI1 and GI2, which are separated from each other, may be formed in the trench TR. The bit lines BL may be partially exposed to the trench TR (e.g., see FIG. 10A).

Each of the first and second active pillars ACP1 and ACP2 may include the horizontal portion HP1 or HP2, which is in contact with the bit line BL, and the vertical portion VP1 or VP2, which vertically extends from the horizontal portion HP1 or HP2. In an embodiment, the side surfaces EN1 and EN2 of the horizontal portions HP1 and HP2 of the first and second active pillars ACP1 and ACP2 may be vertically aligned to the side surfaces of the first and second word lines WL1 and WL2.

After the formation of the first and second active pillars ACP1 and ACP2, a first insulating layer IDL1 may be formed between adjacent ones of the first and second word lines WL1 and WL2. The formation of the first insulating layer IDL1 may include depositing an insulating layer to fill a space between the first and second word lines WL1 and WL2 and recessing the insulating layer to expose top surfaces of the first and second word lines WL1 and WL2.

The formation of the first insulating layer IDL1 may further include forming the first air gap AG1 in a lower portion of the first insulating layer IDL1. By controlling a step coverage property in a process of depositing the first insulating layer IDL1, it may be possible to selectively form the first air gap AG1 in the lower portion of the first insulating layer IDL1. In the present embodiment, the first air gap AG1 may be formed between the first and second side surfaces EN1 and EN2 of the first and second horizontal portions HP1 and HP2 facing each other.

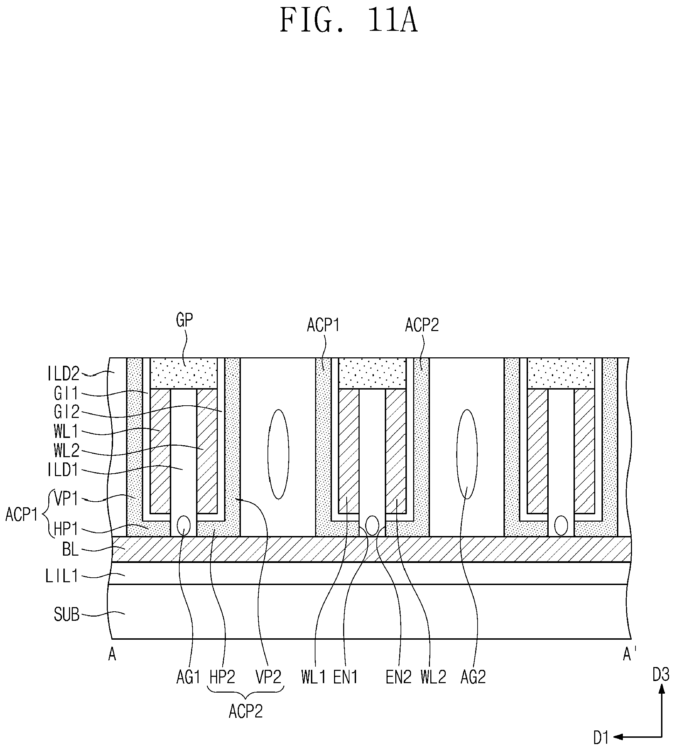

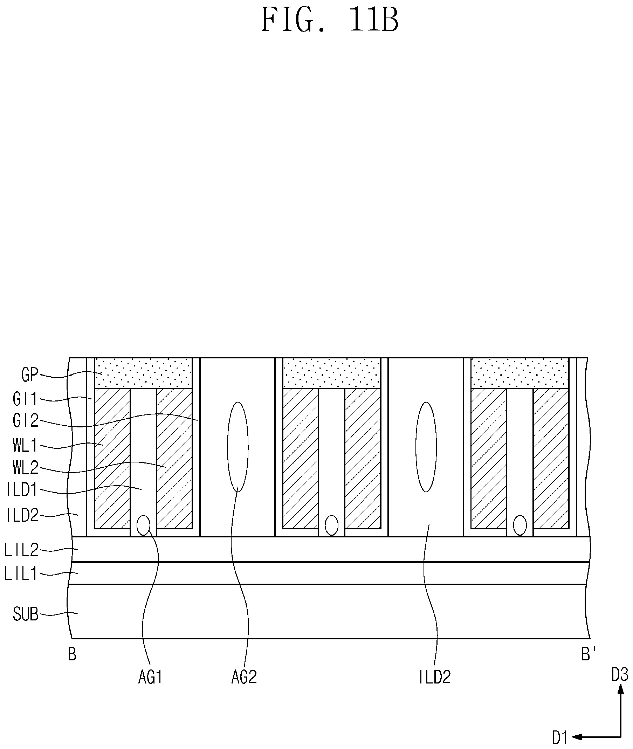

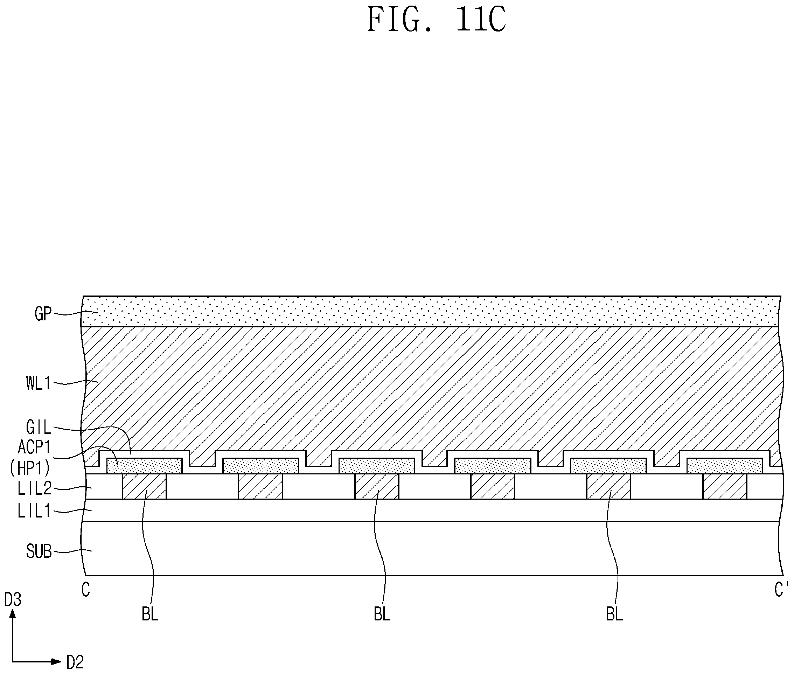

Referring to FIG. 4 and FIGS. 11A to 11C, the gate capping pattern GP may be formed on the first insulating layer IDL1 to cover the top surfaces of the first and second word lines WL1 and WL2. After the formation of the gate capping pattern GP, a removal process may be performed to selectively remove the mold layer MOL. As a result of the removal of the mold layer MOL, the top surfaces of the bit lines BL may be exposed between the first and second active pillars ACP1 and ACP2. The vertical portions VP1 and VP2 of the first and second active pillars ACP1 and ACP2 may be exposed by the process of removing the mold layer MOL.

The second insulating layer ILD2 may be formed to fill a space between the vertical portions VP1 and VP2 of the first and second active pillars ACP1 and ACP2. The formation of the second insulating layer ILD2 may include depositing an insulating layer to fill a space between the vertical portions VP1 and VP2 of the first and second active pillars ACP1 and ACP2 and recessing the insulating layer to expose the top surfaces of the vertical portions VP1 and VP2.

The formation of the second insulating layer IDL2 may further include forming the second air gap AG2 in the second insulating layer IDL2. By controlling a step coverage property in a process of depositing the second insulating layer IDL2, it may be possible to selectively form the second air gap AG2 in the second insulating layer IDL2. In the present embodiment, the second air gap AG2 may be located at a level higher than the first air gap AG1 relative to the substrate SUB. The second air gap AG2 may be larger than the first air gap AG1. Due to the presence of the second air gap AG2, the second insulating layer IDL2 may have a lower dielectric constant.

Referring back to FIG. 4 and FIGS. 5A to 5C, the landing pads LP may be formed on the first and second active pillars ACP1 and ACP2, respectively. A lower portion of the landing pad LP may be formed to be in contact with the top surface of the vertical portion VP1 or VP2 of the active pillar ACP. The landing pad LP may be formed to be offset from the active pillar ACP coupled thereto. Elements or components described as "connected" or "coupled" may refer to physical and/or electrical connection or coupling.

The formation of the landing pads LP may include forming the insulating pattern INP to define the landing pads LP from a metal layer. The data storage patterns DSP may be formed on the landing pads LP, respectively.

In an embodiment, the formation of the data storage pattern DSP may include forming a bottom electrode, which extends in the third direction D3, on the landing pad LP, forming a capacitor dielectric layer on the bottom electrode, and forming a top electrode on the capacitor dielectric layer.

Hereinafter, various embodiments of the inventive concept will be described below. For concise description, an element previously described with reference to FIGS. 4 and 5A to 5C may be identified by the same reference number without repeating an overlapping description thereof.

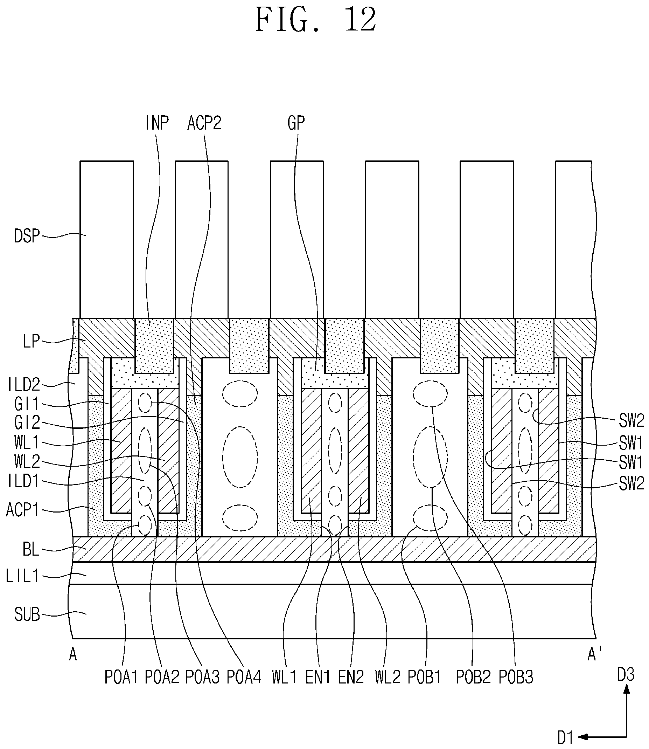

FIGS. 12 to 15 are sectional views, each of which is taken along the line A-A' of FIG. 4 to illustrate a semiconductor memory device according to an embodiment of the inventive concept.

Referring to FIG. 12, the first air gap AG1 may be formed in at least one of first to fourth portions or positions POA1 to POA4 of the first insulating layer ILD1. The first portion POA1 may be interposed between the first and second side surfaces EN1 and EN2 of the first and second horizontal portions HP1 and HP2. For example, the first air gap AG1 shown in FIG. 5A may be an example of an air gap, which is formed at the first portion POA1 of the first insulating layer ILD1.

The second portion POA2 may be a lower portion of the first insulating layer ILD1 interposed between the first and second word lines WL1 and WL2. The third portion POA3 may be an intermediate portion of the first insulating layer ILD1 interposed between the first and second word lines WL1 and WL2. The fourth portion POA4 may be an upper portion of the first insulating layer ILD1 interposed between the first and second word lines WL1 and WL2.

In an embodiment, the first air gap AG1 may be formed in one of the first to fourth portions POA1 to POA4. In another embodiment, the first air gap AG1 may be formed in at least two portions of the first to fourth portions POA1 to POA4. That is, the first air gap AG1 may include one or more air gaps in respective portions POA1 to POA4 of the first insulating layer ILD1, which are closer to or farther from the substrate SUB relative to one another. Each air gap AG1 is distinct or separated from one another by regions of the first insulating layer ILD1 therebetween.

The second air gap AG2 may be formed in at least one of first to third portions POB1 to POB3 in the second insulating layer ILD2. The first portion POB1 may be a lower portion of the second insulating layer ILD2 interposed between the first and second active pillars ACP1 and ACP2. The second portion POB2 may be an intermediate portion of the second insulating layer ILD2 interposed between the first and second active pillars ACP1 and ACP2. The third portion POB3 may be an upper portion of the second insulating layer ILD2 interposed between the first and second active pillars ACP1 and ACP2.

For example, the second air gap AG2 shown in FIG. 5A may be an example of an air gap, which is formed at the second portion POB2 of the second insulating layer ILD2. In an embodiment, the second air gap AG2 may be formed in one of the first to third portions POB1 to POB3. In an embodiment, the second air gap AG2 may be formed in at least two portions of the first to third portions POB1 to POB3. That is, the second air gap AG2 may include one or more air gaps in respective portions POB1 to POB3 of the second insulating layer ILD2, which are closer to or farther from the substrate SUB relative to one another, and each air gap AG2 is distinct or separated from one another by regions of the first insulating layer ILD2 therebetween

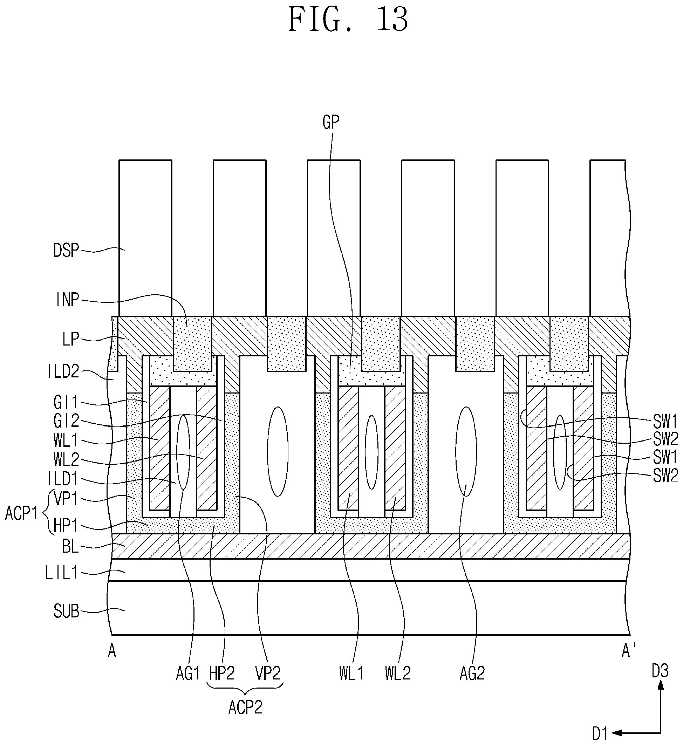

Referring to FIG. 13, the first and second active pillars ACP1 and ACP2, which are adjacent to each other with the word lines WL1 and WL2 interposed therebetween, may not be disconnected from each other to form a single object. In detail, the first horizontal portion HP1 of the first active pillar ACP1 may be connected to the second horizontal portion HP2 of the second active pillar ACP2, such that the horizontal portions HP1, HP2 continuously extend between the vertical portions VP1 and VP2. The first air gap AG1 may be formed in one of the second to fourth portions POA2, POA3, and POA4 of FIG. 12, but may not be formed in portion POA1 due to continuous extension of the horizontal portions HP1, HP2 of the active pillars ACP1 and ACP2.

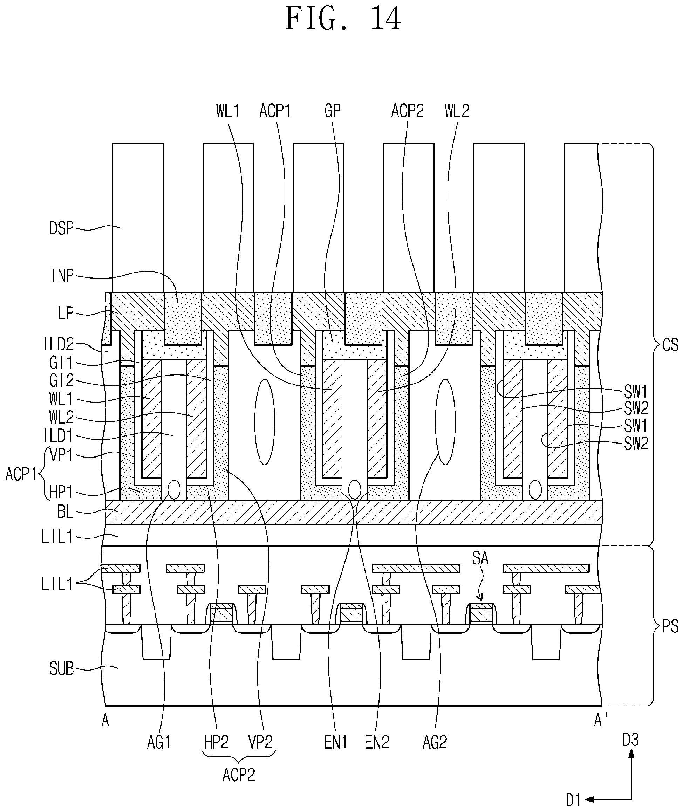

Referring to FIG. 14, the semiconductor memory device may include the peripheral circuit structure PS on the substrate SUB and the cell array structure CS on the peripheral circuit structure PS. The substrate SUB may be, for example, a single-crystalline silicon wafer.

The peripheral circuit structure PS may be disposed between the substrate SUB and the first lower insulating layer LIL1. The peripheral circuit structure PS may include core and peripheral circuits SA provided on the substrate SUB, a peripheral circuit insulating layer covering the core and peripheral circuits SA, and peripheral metal structures PCL disposed in the peripheral circuit insulating layer.

The core and peripheral circuits SA may include the row and column decoders 2 and 4, the sense amplifier 3, and the control logic 5 described with reference to FIG. 1. In an embodiment, the core and peripheral circuits SA may include NMOS transistors and PMOS transistors on the substrate SUB. The peripheral metal structures PCL may include a plurality of metal patterns and a plurality of metal plugs connecting the metal patterns.

The core and peripheral circuits SA may be electrically connected to the bit lines BL through the peripheral metal structures PCL. In other words, the sense amplifiers may be electrically connected to the bit lines BL, and each of the sense amplifiers may be configured to amplify and output a difference between voltage levels sensed by a pair of the bit lines BL.

The cell array structure CS may include the memory cells with the vertical channel transistors, like the embodiments described above. The bit lines BL of the cell array structure CS may be disposed to be adjacent to the peripheral circuit structure PS. Since the bit lines BL are disposed to be adjacent to the peripheral circuit structure PS, an electric connection path (i.e., an electrical length of the connections) between the bit lines BL and the core and peripheral circuits SA may be decreased.

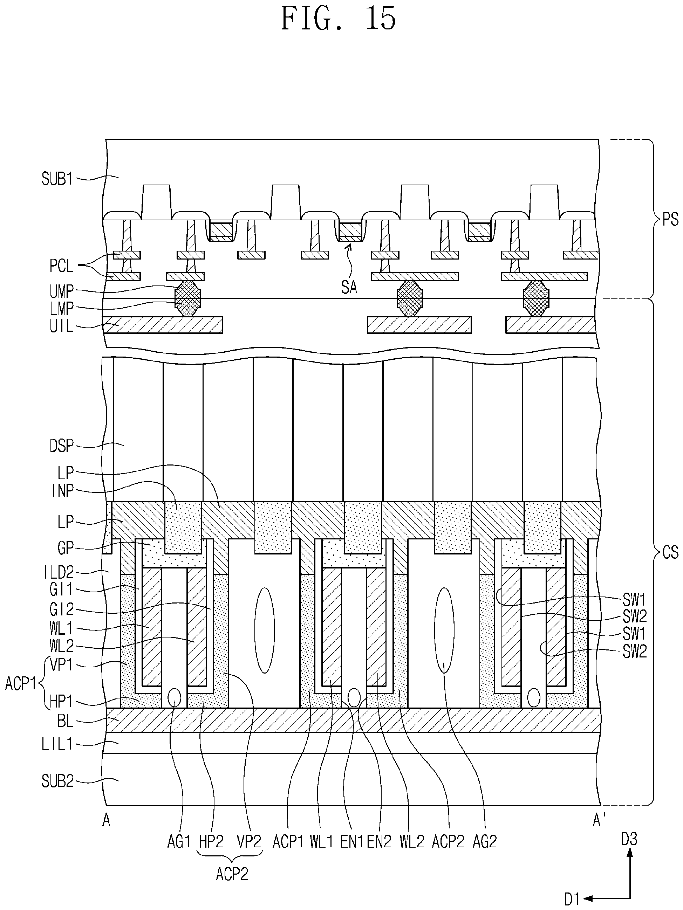

Referring to FIG. 15, the semiconductor memory device may include the cell array structure CS, which includes lower metal pads LBM provided at the uppermost level thereof, and the peripheral circuit structure PS, which includes upper metal pads UBM provided at the uppermost level thereof. Here, the first metal pads LMP of the cell array structure CS may be electrically and physically connected to the second metal pads UMP of the peripheral circuit structure PS by a bonding method. The first and second metal pads LMP and UMP may be formed of or include at least one of metallic materials (e.g., copper (Cu)).

The cell array structure CS may be provided on the second substrate SUB2. Upper interconnection lines UIL may be provided in the uppermost portion of the cell array structure CS. The upper interconnection lines UIL may be electrically connected to the word and bit lines WL and BL of the cell array structure CS. The lower metal pads LBM may be provided on the upper interconnection lines UIL.

The peripheral circuit structure PS may include the core and peripheral circuits SA provided on the first substrate SUB1, with a peripheral circuit insulating layer covering the core and peripheral circuits SA, and the peripheral metal structures PCL disposed in the peripheral circuit insulating layer. The upper metal pads UBM may be connected to the peripheral metal structures PCL.

In an embodiment, the semiconductor memory device may be formed by forming the cell array structure CS, which includes the memory cells, on the second substrate SUB2, forming the peripheral circuit structure PS, which includes the core and peripheral circuits, on the first substrate SUB1, and connecting the first substrate SUB1 to the second substrate SUB2 using a bonding method. For example, the lower metal pads LBM of the cell array structure CS may be electrically and physically connected to the upper metal pads UBM of the peripheral circuit structure PS by the bonding method, defining a bonding interface therebetween. Spatially relative terms, such as "under," "below," "lower," "over," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "under" other elements or features would then be oriented "above" or "over" the other elements or features. Thus, the term "below" can encompass both an orientation of above and below. The device may be otherwise oriented (rotated 90 degrees or at other orientations), and the spatially relative descriptors used herein may be interpreted accordingly.

In a semiconductor memory device according to an embodiment of the inventive concept, an air gap may be provided between adjacent ones of active pillars and between adjacent ones of word lines. Hence, it may be possible to reduce disturbance and coupling-noise issues between memory cells. Furthermore, an insulating layer between the memory cells may also include an air gap, which may reduce an effective dielectric constant of the insulating layer and thereby improve the electrical characteristics of the device.

While example embodiments of the inventive concept have been particularly shown and described, it will be understood by one of ordinary skill in the art that variations in form and detail may be made therein without departing from the scope of the attached claims.

## Claims

1. A semiconductor memory device, comprising:
a bit line on a substrate and extending in a first direction;
a first active pillar and a second active pillar on the bit line, the first active pillar comprising a first horizontal portion coupled to the bit line and a first vertical portion extending from the first horizontal portion in a vertical direction away from the substrate, the second active pillar comprising a second horizontal portion coupled to the bit line and a second vertical portion extending from the second horizontal portion in the vertical direction;
a first word line and a second word line on the first and second horizontal portions of the first and second active pillars, respectively, and extending in a second direction crossing the first direction; and
a first insulating layer between the first and second word lines,
wherein a first side surface of the first horizontal portion and a second side surface of the second horizontal portion face each other, and
wherein the first insulating layer comprises a first air gap between the first side surface and the second side surface.

2. The semiconductor memory device of claim 1, wherein the first and second active pillars are symmetric with respect to each other about an axis extending in the vertical direction.

3. The semiconductor memory device of claim 1 or claim 2, wherein the first and second active pillars comprise at least one amorphous oxide semiconductor material, wherein the at least one amorphous oxide semiconductor material includes InGaZnO, InGaSiO, InSnZnO, InZnO, ZnO, ZnSnO, ZnON, ZrZnSnO, SnO, HfInZnO, GaZnSnO, AlZnSnO, YbGaZnO, and/or InGaO.

4. The semiconductor memory device of any preceding claim, further comprising:
a third active pillar on the bit line; and
a second insulating layer between the second active pillar and the third active pillar,
wherein the second insulating layer comprises a second air gap.

5. The semiconductor memory device of claim 4, wherein a first distance between the first and second word lines is smaller than a second distance between the second active pillar and the third active pillar.

6. The semiconductor memory device of claim 4 or claim 5, wherein the second air gap is positioned to be higher than the first air gap relative to the substrate.

7. The semiconductor memory device of any of claims 4-6, wherein the second air gap is larger than the first air gap.

8. The semiconductor memory device of any preceding claim, further comprising:
landing pads on the first and second vertical portions, respectively; and
data storage patterns on the landing pads, respectively.

9. The semiconductor memory device of claim 8, wherein each of the data storage patterns comprises a capacitor.

10. The semiconductor memory device of any preceding claim, further comprising a peripheral circuit structure including peripheral circuits, which are on the substrate,
wherein the peripheral circuit structure is below the bit line.
